# FASCICULE DE BREVET EUROPEEN

(11) **EP 0 782 266 B1**
(45) Date de publication et mention de la délivrance du brevet: **23.07.2003**
(21) Numéro de dépôt: 96402903.7
(22) Date de dépôt: 26.12.1996
(51) Int. Cl.: H03K 17/12, H02M 1/088

(54) **Commutateur impulsionnel de puissance capable de fournir des impulsions de courant de forte intensité et de faible durée**
Gepulster Leistungswandler zur Erzeugung von kurzzeitigen Hochstrompulsen
Pulse power converter suitable for generating high current pulses of short duration

(30) Priorité: 27.12.1995 FR 9515546
(43) Date de publication de la demande: 02.07.1997
(73) Titulaire: COMMISSARIAT A L'ENERGIE ATOMIQUE, 75015 Paris Cédex 15 (FR)
(72) Inventeur: Chatroux, Daniel, 26200 Montelimar (FR); Lauzenaz, Yvan, 38210 Tullins (FR)
(74) Mandataire: Poulin, Gérard

(56) Documents cités:
- EP-A- 0 517 261
- FR-A- 2 673 494
- PROCEEDINGS OF THE POWER MODULATOR SYMPOSIUM, SAN DIEGO, JUNE 26 - 28, 1990, no. SYMP. 19, 26 Juin 1990, INSTITUTE OF ELECTRICAL AND ELECTRONICS ENGINEERS, pages 367-370, XP000207408 VORSTER A ET AL: "MOSMATRIX - A REPLACEMENT FOR THYRATRONS"

## Description

### DOMAINE TECHNIQUE

La présente invention telle que définie dans la revendication concerne un convertisseur d'énergie électrique dans le domaine de l'électronique de puissance et, plus précisément, un commutateur impulsionnel de puissance capable de fournir des impulsions de courant de forte intensité et de faible durée.

Ce commutateur a une tension de service élevée, qui peut être de plusieurs dizaines de kilovolts, et il est capable de commuter des courants électriques de grande intensité, qui peut valoir plusieurs milliers d'ampères.

Ce commutateur objet de l'invention est du type des générateurs d'impulsions rapides, dont le temps de commutation est inférieur à 50 ns, et à fréquence de récurrence élevée, pouvant aller de plusieurs kilohertzs à plusieurs dizaines de kilohertzs.

Ce commutateur est utilisable dans les alimentations impulsionnelles des lasers à vapeur de cuivre et des lasers à halogénure de cuivre comme les lasers à bromure de cuivre et les lasers à CuHBr.

### ÉTAT DE LA TECHNIQUE ANTÉRIEURE

A l'heure actuelle et de manière classique, les commutateurs haute tension de puissance sont réalisés au moyen de tubes à gaz appelés "thyratrons".

On consultera à ce sujet les documents (1) et (2) qui, comme les autres documents cités par la suite, sont mentionnés à la fin de la présente description.

Cependant, de plus en plus apparaissent des commutateurs appelés "commutateurs à l'état solide" qui résultent de la mise en série (voir le document (3)) et/ou la mise en parallèle (voir le document (4)) de composants électroniques à grille isolée ("*isolated gate*").

Le document EP-A-0 517 261 divulgue un exemple de mise en parallèle de composants électroniques à grille isolée.

Par exemple, la mise en série de transistors bipolaires à grille isolée, qui sont désignés par le sigle IGBT, permet d'obtenir des commutateurs capables de fonctionner sous haute tension tout en étant capable de commuter des courants électriques de forte intensité.

On consultera à ce sujet le document (5).

En ce qui concerne les transistors à effet de champ à grille isolée comme les transistors MOSFET, leur courant impulsionnel maximum n'étant que de quelques dizaines d'ampères, on utilise une matrice de tels transistors MOSFET pour réaliser les commutateurs considérés.

On consultera à ce sujet les documents (4), (10) et (11).

La mise en série de ces transistors MOSFET permet de supporter la haute tension et la mise en parallèle de ces transistors MOSFET permet de commuter de forts courants.

La mise en série des transistors MOSFET (voir le document (8)) nécessite, pour l'obtention d'un commutateur rapide, un type de commande qui possède une grande isolation galvanique tout en assurant une excellente synchronisation des ordres au niveau des transistors.

Pour ce faire, on utilise de façon classique des transformateurs d'impulsions généralement toriques et comportant un ou plusieurs enroulements dans leur circuit primaire et un ou plusieurs enroulements dans leur circuit secondaire.

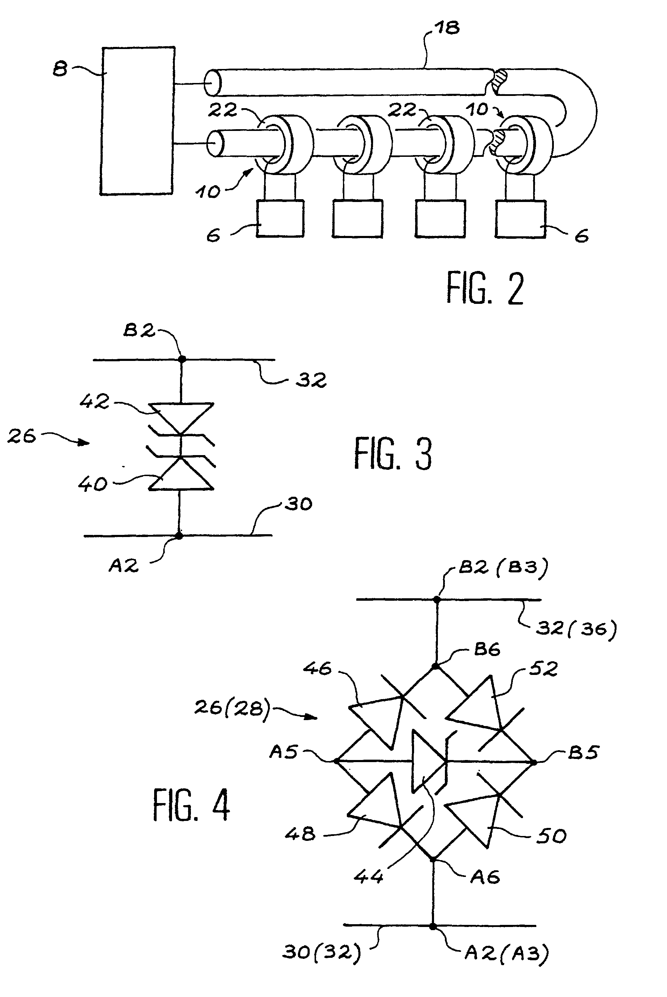

A ce sujet on consultera les documents (6) et (7) et, en particulier, la figure 2 de chacun de ces documents (6) et (7).

L'ordre de mise en conduction est une impulsion de courant qui est envoyée au circuit primaire d'un tel transformateur et qui est retransmise au circuit secondaire de ce transformateur par couplage magnétique, afin de charger les grilles des transistors.

La décharge de ces grilles peut se faire au bout d'un temps qui peut aller de quelques nanosecondes à plusieurs microsecondes suivant les types de montage utilisés au niveau du circuit secondaire du transformateur.

En général, la durée d'une arche de courant électrique qui traverse le commutateur est fonction de l'impédance de la charge alimentée par ce commutateur et non de la durée de l'ordre de commutation.

Dans le cas d'un thyratron, la mise en conduction de ce thyratron est commandée et le blocage du thyratron s'effectue dès que le courant qui traverse ce dernier s'annule.

En ce qui concerne les matrices de transistors de type MOSFET, ces matrices sont commandées lorsqu'elles sont mises en conduction et le blocage de ces matrices s'effectue au bout d'un certain temps qui est défini par des résistances de décharge des grilles des transistors MOSFET.

Si l'on veut régler le temps de conduction, il faut utiliser des systèmes qui sont commandés à la mise en conduction et au blocage.

Ceci est généralement réalisé grâce à deux transformateurs d'impulsions.

A ce sujet on consultera le document (9).

A l'un de ces deux transformateurs d'impulsions, on fournit une impulsion de courant pour créer l'ordre de mise en conduction (état ON) puis, à l'autre transformateur d'impulsions, on fournit une impulsion de courant afin de provoquer le blocage des transistors (état OFF).

Les rendements des lasers à vapeur de cuivre et des lasers à halogénure de cuivre (comme par exemple les lasers à bromure de cuivre) dépendent de la durée de l'impulsion de courant au sein de tels lasers.

A ce sujet on consultera le document (12).

Seule est utile l'énergie apportée par la partie de l'impulsion de courant qui a lieu avant l'impulsion laser.

Une solution classique pour diminuer la durée de l'impulsion de courant consiste à décharger, dans le laser que l'on veut commander, un petit condensateur qui a été chargé sous une haute tension.

En passant d'un condensateur de 10 nF chargé sous 20 kV à un condensateur de 1 nF chargé sous 100 kV, on atteint une durée d'impulsion de courant de 150 ns au sein du laser.

Il est à noter qu'on se situe, du point de vue de l'application de la haute tension, au niveau d'une limite technologique, ce qui empêche de diminuer davantage la durée de l'impulsion de courant.

### EXPOSÉ DE L'INVENTION

La présente invention concerne un commutateur qui est susceptible de supporter de très hautes tensions (plusieurs dizaines de kilovolts) et qui est susceptible de se fermer et de s'ouvrir très rapidement (temps de fermeture et temps d'ouverture inférieurs à 20 ns) pour fournir des impulsions de courant de forte intensité (plusieurs milliers d'ampères) et de faible durée (de l'ordre de 50 ns).

Pour ce faire, la présente invention utilise une matrice de transistors à grille isolée tels que des transistors à effet de champ à grille isolée comme par exemple les transistors MOSFET.

Il est préférable, dans la présente invention, de commander la mise en conduction et le blocage de cette matrice par un unique câble de commande afin d'obtenir un commutateur qui soit simple pour être réalisable industriellement sur un circuit imprimé et à moindre coût.

Il est également préférable que ce commutateur ait une très faible inductance parasite pour ne pas diminuer sa vitesse de commutation et que l'énergie qu'il dissipe puisse être évacuée dans un fluide tel que l'huile ou l'air.

De façon précise, la présente invention a pour objet un commutateur impulsionnel de puissance, apte à fournir des impulsions de courant de forte intensité et de faible durée, ce commutateur étant caractérisé en ce qu'il comprend :
- une matrice de transistors, cette matrice comprenant au moins une rangée de transistors à grille isolée, ces transistors étant montés en parallèle et répartis en groupes de transistors,
- des dispositifs de commande qui sont respectivement associés à ces groupes et destinés à commander les transistors,
- des moyens de génération d'impulsions de courant qui permettent la commande des transistors par mise en conduction et blocage, et
- des transformateurs d'impulsions qui sont respectivement associés aux dispositifs de commande et par l'intermédiaire desquels les moyens de génération d'impulsions sont couplés à ces dispositifs de commande,
et en ce que chacun des dispositifs de commande comprend :
- des moyens d'amortissement de la tension due à la démagnétisation du transformateur correspondant,
- des moyens d'écrêtage bidirectionnel de tension, et
- des moyens d'écrêtage monodirectionnel de tension.

Selon un mode de réalisation préféré du commutateur objet de l'invention, les transistors sont des transistors à effet de champ à grille isolée tels que les transistors MOSFET.

De préférence, les moyens d'amortissement sont montés entre les extrémités du circuit secondaire du transformateur correspondant.

Ces moyens d'amortissement peuvent comprendre une résistance électrique.

De préférence également, les moyens d'écrêtage bidirectionnel sont montés entre la ligne reliant les sources et la ligne reliant les grilles des transistors de ladite rangée de transistors.

Ces moyens d'écrêtage bidirectionnel peuvent être choisis dans le groupe comprenant une diode Zener bidirectionnelle, deux diodes Zener tête-bêche, une diode Zener placée au sein d'un pont de diodes.

De préférence également, les moyens d'écrêtage monodirectionnel sont montés entre la ligne reliant les drains et la ligne reliant les grilles des transistors de ladite rangée de transistors.

En variante, ces moyens d'écrêtage monodirectionnel sont montés entre la ligne reliant les drains et la ligne reliant les sources des transistors de ladite rangée de transistors.

Ces moyens d'écrêtage monodirectionnel peuvent être choisis dans le groupe comprenant une diode Zener bidirectionnelle, une diode Zener et une diode tête-bêche, une diode Zener placée au sein d'un pont de diodes.

Selon un mode de réalisation préféré du commutateur objet de l'invention, dans chaque transformateur d'impulsions, le circuit primaire comprend une seule spire conductrice et le circuit secondaire comprend une seule spire conductrice.

De préférence également, le commutateur objet de l'invention comprend une ligne électrique unique constituant la spire conductrice du circuit primaire de chacun des transformateurs d'impulsions.

Les moyens de génération d'impulsions peuvent comprendre un pont onduleur.

### BRÈVE DESCRIPTION DES DESSINS

La présente invention sera mieux comprise à la lecture de la description d'exemples de réalisation donnés ci-après, à titre purement indicatif et nullement limitatif, en faisant référence aux dessins annexés sur lesquels :
- la figure 1 est une vue schématique d'un mode de réalisation particulier du commutateur impulsionnel objet de la présente invention,
- la figure 2 illustre schématiquement la possibilité d'utiliser un seul câble de commande pour la mise en conduction et pour le blocage des transistors du commutateur de la figure 1,
- les figures 3 à 5 sont des vues schématiques d'exemples de réalisation de moyens d'écrêtage de tension dans le commutateur de la figure 1,
- la figure 6 est une vue schématique d'un pont onduleur utilisable pour la génération d'impulsions dans le commutateur de la figure 1, et
- la figure 7 est une vue schématique d'un autre mode de réalisation particulier du commutateur objet de l'invention.

### EXPOSÉ DÉTAILLÉ DE MODES DE RÉALISATION PARTICULIERS

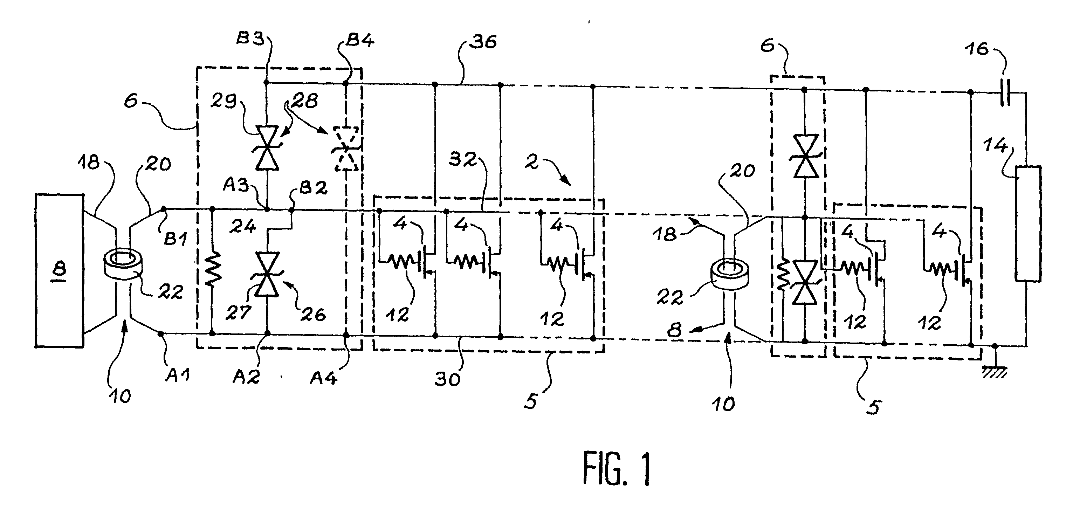

Le commutateur impulsionnel conforme à l'invention, qui est schématiquement représenté sur la figure 1, comprend une matrice 2, à une rangée, de transistors à grille isolée 4 qui sont montés en parallèle et répartis en une pluralité de groupes 5 de transistors.

Le commutateur impulsionnel de la figure 1 comprend également des dispositifs de commande 6, qui sont respectivement associés aux groupes 5 de transistors 4 et destinés à commander ces transistors 4.

Le commutateur impulsionnel de la figure 1 comprend aussi des moyens 8 de génération d'impulsions de courant qui permettent la commande des transistors de la matrice 2 par mise en conduction et blocage.

Ce commutateur de la figure 1 comprend également des transformateurs d'impulsions 10, qui sont respectivement associés aux dispositifs de commande et par l'intermédiaire desquels les moyens de génération d'impulsions 8 sont couplés à ces dispositifs de commande 6.

Dans l'exemple représenté, les transistors à grille isolée 4 sont des transistors à effet de champ de type MOSFET.

A titre purement indicatif et nullement limitatif, on utilise des transistors du type IRF 840 fabriqués par la société International Rectifier.

Une impédance 12, qui est une résistance électrique dans l'exemple représenté sur la figure 1, est associée à chaque transistor 4 et sert à la synchronisation des ordres de commande au niveau des transistors.

Plus précisément, cette résistance électrique 12 constitue une impédance de grille permettant d'obtenir des courants de commande distribués de façon uniforme entre les différents transistors 4.

Le commutateur conforme à l'invention, qui est schématiquement représenté sur la figure 1, a la fonction d'un interrupteur permettant de faire circuler un courant électrique dans un circuit comportant une charge 14, comme par exemple un laser à vapeur de cuivre, ainsi qu'un réservoir d'énergie électrique 16 qui, dans l'exemple représenté, est formé par un condensateur.

Le circuit primaire de chaque transformateur d'impulsions 10 est relié aux moyens de génération d'impulsions de courant 8 et comprend une seule spire 18.

Le circuit secondaire de ce transformateur d'impulsions 10 est relié au dispositif de commande correspondant 6 et comprend aussi une seule spire 20.

Il s'agit d'un transformateur torique c'est-à-dire que son noyau 22 a la forme d'un tore.

Chaque dispositif de commande 6 comprend :
- des moyens 24 d'amortissement de la tension due à la démagnétisation du transformateur 10 correspondant,
- des moyens 26 d'écrêtage bidirectionnel de tension, et
- des moyens 28 d'écrêtage monodirectionnel de tension.

On voit sur la figure 1 une ligne électrique 30 qui relie toutes les sources des transistors 4 entre elles et qui est appelée "ligne de source".

On voit aussi une ligne électrique 32 qui relie toute les grilles des transistors 4 entre elles par l'intermédiaire des résistances 12 et qui est appelée "ligne de grille".

On voit également une ligne électrique 36 qui relie tous les drains des transistors 4 entre eux et qui est appelée "ligne de drain".

Comme on le voit sur la figure 1, les extrémités de la spire 20 du circuit secondaire du transformateur 10 sont respectivement reliées à la ligne de source 30 et à la ligne de grille 32.

Dans l'exemple de la figure 1, les moyens d'amortissement 24 sont constitués par une résistance électrique de quelques ohms, qui est montée entre les bornes A1 et B1 de la spire 20 du transformateur 10.

Les moyens 26 d'écrêtage bidirectionnel de tension sont, dans l'exemple de la figure 1, constitués par une diode Zener bidirectionnelle 27 dont les bornes sont connectées à des points A2 et B2 appartenant respectivement à la ligne de source 30 et à la ligne de grille 32.

De plus, on voit sur la figure 1 que ces moyens d'écrêtage bidirectionnel de tension sont montés entre le couple de points A1, B1 et l'ensemble des impédances de grille 12 du groupe 5 associé, lequel ensemble constitue un réseau d'équilibrage.

Les moyens 28 d'écrêtage monodirectionnel de tension sont, dans l'exemple de la figure 1, constitués par une autre diode Zener bidirectionnelle 29 qui est montée entre des points A3 et B3 appartenant respectivement à la ligne de grille 32 et à la ligne de drain 36, comme on le voit sur la figure 1.

Dans une variante de réalisation schématiquement représentée en traits mixtes sur la figure 1, cette autre diode de Zener 28 est montée entre un point A4 de la ligne de source 30 et un point B4 de la ligne de drain 36 comme on le voit sur la figure 1.

L'association des moyens d'amortissement 24, des moyens d'écrêtage bidirectionnel 26 et des moyens d'écrêtage monodirectionnel 28 à chaque transformateur d'impulsion 10 conduit à des dispositifs de commande 6 d'une grande simplicité qui permet une réalisation industrielle et peu coûteuse du commutateur sur un circuit imprimé.

La structure des dispositifs de commande 6 permet également de n'utiliser qu'un seul câble de commande pour la mise en conduction et le blocage des transistors, contrairement aux commutateurs connus qui utilisent une pluralité de tels câbles.

Ceci est schématiquement illustré par la figure 2 où l'on voit un tel câble de commande 18 constituant l'unique spire du circuit primaire de chacun des transformateurs 10 respectivement associés aux dispositifs de commande 6 du commutateur.

On voit sur la figure 2 que ce câble 18 traverse chacun des noyaux toriques 22 des transformateurs d'impulsion 10.

L'ordre de mise en conduction est une impulsion de courant positive dans ce câble 18 afin de charger les grilles des transistors 4 (figure 1) à travers les résistances électriques 12 (impédances d'entrée).

L'ordre de blocage, qui est ensuite donné, est une impulsion de courant en sens contraire, donc négative, afin de décharger ces grilles et donc de forcer le blocage des transistors 4 du commutateur.

La figure 3 illustre schématiquement la possibilité de réaliser les moyens 26 d'écrêtage bidirectionnel de tension au moyen de deux diodes Zener 40 et 42 monté tête-bêche.

La figure 4 illustre schématiquement la possibilité de réaliser ces moyens 26 d'écrêtage bidirectionnel de tension au moyen d'une diode Zener 44 montée entre deux noeuds A5 et B5 d'un pont de diodes, les diodes (ordinaires) de ce pont portant respectivement les références 46, 48, 50 et 52.

Les deux autres noeuds A6 et B6 de ce pont de diodes sont respectivement reliés aux points A2 et B2 comme le montre la figure 4.

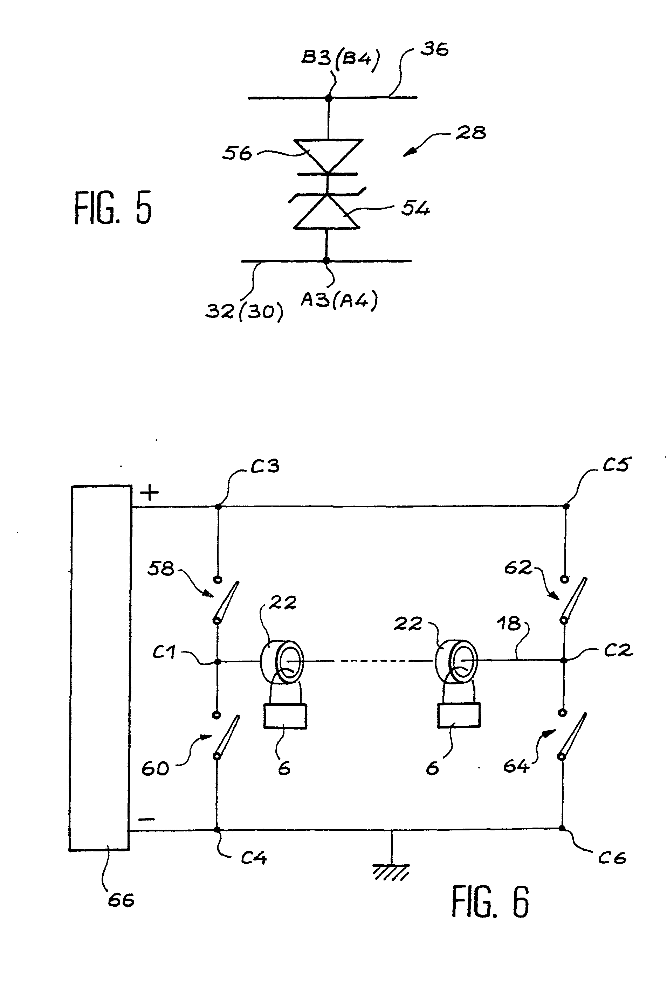

On précise également que les moyens 28 d'écrêtage monodirectionnel de tension peuvent être réalisés au moyen d'une diode Zener 54 et d'une diode (ordinaire) 56 montées tête-bêche comme le montre schématiquement la figure 5.

Pour réaliser ces moyens 28 d'écrêtage monodirectionnel de tension, on peut également utiliser la diode Zener au sein du pont de diodes de la figure 4.

Les faibles durée de commutation d'un commutateur conforme à l'invention, comme celui de la figure 1, sont obtenues en diminuant le temps séparant l'ordre de mise en conduction et l'ordre de blocage.

Ces deux ordres sont fournis à la spire 18 du circuit primaire du transformateur 10 (unique câble primaire) sous la forme de deux impulsions de courant de sens contraires.

L'une des ces impulsions, ou impulsion ON, sert à charger les grilles des transistors du commutateur pour en provoquer la mise en conduction.

L'autre impulsion, ou impulsion OFF, sert à décharger ces grilles pour forcer le blocage.

Cette technique de commande, alliée à la simplicité des circuits secondaires des transformateurs du commutateur, permet d'obtenir des vitesses de commutation de l'ordre d'une quinzaine de nanosecondes et des largeurs d'impulsion de l'ordre de 40 nanosecondes, indépendamment de la charge 14 (figure 1) que l'on veut alimenter.

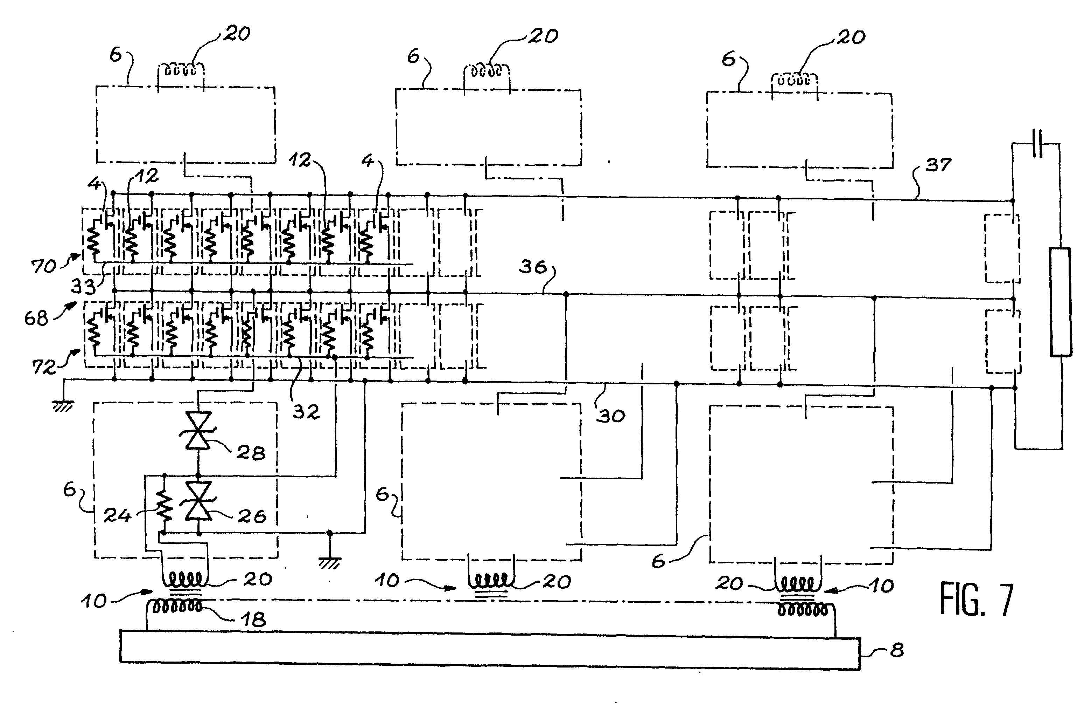

Ces deux impulsions de courant (impulsion ON puis impulsion OFF) dans le câble du circuit primaire des transformateurs du commutateur peuvent être fournies par un pont onduleur comme l'illustre schématiquement la figure 6, ce pont onduleur formant donc les moyens 8 de génération d'impulsions.

De façon connue, ce pont onduleur comprend quatre interrupteurs 58, 60, 62 et 64.

Les interrupteurs 58 et 60 ont une borne commune notée C1.

Les interrupteurs 62 et 64 ont une borne commune notée C2.

Les autres bornes des interrupteurs 58, 60, 62 et 64 ont respectivement les références C3, C4, C5 et C6.

Les extrémités du câble de commande 18 sont connectées aux bornes C1 et C2 comme on le voit sur la figure 6.

Les moyens 8 de génération d'impulsions sont munis d'une alimentation électrique continue 66.

La borne positive + de cette alimentation continue est reliée aux bornes C3 et C5 des interrupteurs 58 et 62 tandis que la borne négative - de cette alimentation continue est reliée aux bornes C4 et C6 des interrupteurs 60 et 64 comme on le voit sur la figure 6.

Pour faire fonctionner le pont onduleur et donc former les impulsions de mise en conduction et de blocage, on ferme les interrupteurs 58 et 64 (les interrupteurs 60 et 62 restant ouverts) pour appliquer une tension positive aux bornes du câble de commande 18 et donc engendrer un courant positif dans ce câble 18.

On ouvre ensuite ces interrupteurs 58 et 64 et, tout en laissant ceux-ci ouverts, on ferme les interrupteurs 60 et 62 pour appliquer une tension négative aux bornes du câble de commande 18 et engendrer un courant négatif dans ce câble de commande 18.

Ensuite on ouvre les interrupteurs 60 et 62.

La figure 7 illustre schématiquement un autre commutateur impulsionnel conforme à l'invention.

Ce commutateur de la figure 7 est un commutateur de puissance, capable de supporter plusieurs kilovolts et de commuter plusieurs milliers d'ampères.

Les vitesses de commutation sont typiquement de l'ordre d'une quinzaine de nanosecondes et la durée de l'impulsion peut descendre, indépendamment de la charge 14 alimentée, en-dessous de 50 nanosecondes.

De plus, le commutateur de la figure 7 comme les autres commutateurs conforme à l'invention, allie à la fois simplicité, efficacité et fiabilité.

Ce commutateur de la figure 7 comprend une matrice 68 de transistors à effet de champ 4 de type MOSFET.

Ces transistors sont par exemple du type IRF 840.

La matrice 68 a M lignes ou rangées et N colonnes.

Dans l'exemple représenté, le nombre M est égal à 2 tandis que le nombre N est égal à 24.

Les M lignes sont constituées de transistors 4 montés en parallèle tandis que les N colonnes sont constituées de transistor 4 montés en série.

La tenue en tension du commutateur de la figure 7 et donc N fois la tension maximale de rupture d'un transistor (Nx500 V avec des transistors du type IRF 840).

Le courant impulsionnel maximum que l'on peut obtenir est égal à M fois l'intensité supportable par un transistor (Mx40 A avec des transistors du type IRF 840).

Comme dans le cas de la figure 1, chaque transistor 4 est muni d'une résistance de grille 12.

Les deux lignes de la matrice 68 ont respectivement les références 70 et 72.

Tous les drains des transistors 4 de la ligne 70 sont reliés les uns aux autres par une même ligne électrique 37 appelée "ligne de drain".

Toutes les grilles des transistors 4 sont reliées les unes aux autres par une même ligne électrique 33 appelée "ligne de grille".

Toutes les sources des transistors 4 de la ligne 70 sont reliées les unes aux autres par une même ligne électrique 36 appelée "ligne de source".

Dans la ligne 72 de la matrice 68, tous les drains des transistors sont reliés les uns aux autres par une même ligne de drain qui est confondue avec la ligne de source 36 relative à la ligne 70 de la matrice 68, comme on le voit sur la figure 7.

Toutes les grilles des transistors de la ligne 72 sont reliées les uns aux autres par une même ligne de grille 32 et toutes les sources de ces transistors de la ligne 72 sont reliées les unes aux autres par une même ligne de source 30.

On voit également sur cette figure 7 que les lignes 70 et 72 de transistor sont reliées en série.

Le commutateur de la figure 7 permet à un réservoir 16 d'énergie électrique de fournir des impulsions de fort courant à une charge 14 comme par exemple un laser à vapeur de cuivre.

Chacune des lignes 70 et 72 de la matrice 68 est divisée en trois groupes comprenant chacun huit transistors.

Pour la commande des transistors de la matrice 68, chaque groupe de transistor est associé à un dispositif de commande 6.

Ce dispositif 6 est identique à celui qui a été décrit en faisant référence à la figure 1.

On voit que pour chaque dispositif 6, les liaisons des éléments constitutifs de ce dispositif 6 avec les lignes de drain, de source et de grille sont identiques aux liaisons formées dans le cas de la figure 1.

Dans la matrice 68, la répartition en groupes de transistors permet une bonne distribution des courants de commande et donc une commande simultanée de l'ensemble des transistors.

On voit également sur la figure 7 les transformateurs d'impulsions 10 qui sont respectivement associés aux dispositifs 6.

On voit aussi les circuits secondaires 20 de ces transformateurs mais, pour la clarté de la figure, les circuits primaires 18 ne sont représentés qu'en bas de celle-ci.

On voit également sur la figure 7 les moyens 8 de génération d'impulsions 8 qui sont couplés avec les transformateurs 10.

De préférence, comme dans le cas de la figure 1, on utilise de préférence des transformateurs d'impulsions à noyau torique, chaque circuit secondaire comprend une seule spire et chaque circuit primaire comprend une seule spire, ces spires des circuits primaires des transformateurs 10 étant constituées par un même câble de commande (câble 18 de la figure 2).

Les documents dont il est question dans la présente description sont les suivants :
(1) S. Goldberg, S.I. Martin "Research study on hydrogen Thyratrons" final report, E.G.G. Inc. (1953)
(2) Sailanski "Reducing thyratron losses in CVL Modulator"
(3) Honda, Akira "Field effect transistor circuit configuration" EP 0 048 758 A1 (1979)
(4) G.T. Santamaria, R.M. Ness "High power switching using power FET arrays" Sixth IEEE Pulsed power conference Maxwell Laboratory (1987)
(5) Rodolphe Guidini "Interrupteurs rapides haute tension réalisés par mise en série de composants semiconducteurs pour convertisseur de forte énergie" Rapport de thèse (1995)
(6) Walter E. Milberger, Franklin B. Jones, Charles S. Kerfoot "Pulse modulator" United States Statutory Invention Registration n°H275 (1987)
(7) Behlke "MOSFET - Hochsspannungsschalter mit extrem kurzer Schaltzeit Brevet Allemand DE 36 30 775 C2 (1991)
(8) Walter E. Milberger, Serena Park. "High voltage field effect transistor pulse apparatus" US Patent 4.425.518 (1984)
(9) Franklin B. Jones, Walter E. Milberger "High voltage MOSFET current switch" PCI september 1987 proceedings
(10) A. Vorster. G.L. Bredenkamp "Mosmatrix - A replacement for thyratrons" Nineteenth Power Modulator Symposium (1990)
(11) Mitsubishi Denki Kabushiki Kaisha "Semiconductor switching apparatus" Brevet Japonais JP 314568/89 (1990)
(12) A.N. Soldatov, Y.F. Fedorof, N.A. Yudin "Efficency of a copper vapour laser with partial discharge of a storage capacitor" Quantum Electronics 24(8) 677-678 (1994)

## Revendications

1. Commutateur impulsionnel de puissance, apte à fournir des impulsions de courant de forte intensité et de faible durée, ce commutateur étant
**caractérisé en ce qu'**il comprend :
- une matrice (2, 68) de transistors, cette matrice comprenant au moins une rangée de transistors (4) à grille isolée, ces transistors étant montés en parallèle et répartis en groupes (5) de transistors,
- des dispositifs de commande (6) qui sont respectivement associés à ces groupes et destinés à commander les transistors,
- des moyens (8) de génération d'impulsions de courant qui permettent la commande des transistors par mise en conduction et blocage, et
- des transformateurs d'impulsions (10) qui sont respectivement associés aux dispositifs de commande (6) et par l'intermédiaire desquels les moyens (8) de génération d'impulsions sont couplés à ces dispositifs de commande,
et **en ce que** chacun des dispositifs de commande (6) comprend :
- des moyens (24) d'amortissement de la tension due à la démagnétisation du transformateur correspondant,
- des moyens (26) d'écrêtage bidirectionnel de tension, et
- des moyens (28) d'écrêtage monodirectionnel de tension.

2. Commutateur selon la revendication 1, **caractérisé en ce que** les transistors sont des transistors à effet de champ à grille isolée (4).

3. Commutateur selon l'une quelconque des revendications 1 et 2, **caractérisé en ce que** les moyens (24) d'amortissement sont montés entre les extrémités du circuit secondaire (20) du transformateur (10) correspondant.

4. Commutateur selon la revendication 3, **caractérisé en ce que** les moyens d'amortissement comprennent une résistance électrique (24).

5. Commutateur selon l'une quelconque des revendications 1 à 4, **caractérisé en ce que** les moyens (26) d'écrêtage bidirectionnel sont montés entre la ligne (30) reliant les sources et la ligne (32) reliant les grilles des transistors de ladite rangée.

6. Commutateur selon la revendication 5, **caractérisé en ce que** les moyens (26) d'écrêtage bidirectionnel sont choisis dans le groupe comprenant une diode Zener bidirectionnelle, deux diodes Zener tête-bêche, une diode Zener placée au sein d'un pont de diodes.

7. Commutateur selon l'une quelconque des revendications 1 à 6, **caractérisé en ce que** les moyens (28) d'écrêtage monodirectionnel sont montés entre la ligne (36) reliant les drains et la ligne (32) reliant les grilles des transistors de ladite rangée.

8. Commutateur selon l'une quelconque des revendications 1 à 6, **caractérisé en ce que** les moyens (28) d'écrêtage monodirectionnel sont montés entre la ligne (36) reliant les drains et la ligne (30) reliant les sources des transistors de ladite rangée.

9. Commutateur selon l'une quelconque des revendications 7 et 8, **caractérisé en ce que** les moyens (28) d'écrêtage monodirectionnel sont choisis dans le groupe comprenant une diode Zener bidirectionnelle, une diode Zener et une diode tête-bêche, une diode Zener placée au sein d'un pont de diodes.

10. Commutateur selon l'une quelconque des revendications 1 à 9, **caractérisé en ce que**, dans chaque transformateur d'impulsions (10), le circuit primaire comprend une seule spire conductrice (18) et le circuit secondaire comprend une seule spire conductrice (20).

11. Commutateur selon la revendication 10, **caractérisé en ce qu'**il comprend une ligne électrique unique (18) constituant la spire conductrice du circuit primaire de chacun des transformateurs d'impulsions (10).

12. Commutateur selon l'une quelconque des revendications 1 à 11, **caractérisé en ce que** les moyens de génération d'impulsions comprennent un pont onduleur (58, 60, 62, 64).

## Patentansprüche

1. Gepulster Leistungswandler zur Erzeugung von kurzzeitigen Hochstrompulsen,
**dadurch gekennzeichnet, dass** er umfasst:
- eine Transistoren-Matrix (2, 68), wobei diese Matrix wenigstens eine Reihe Feldeffekttransistoren (4) umfasst und diese Transistoren parallelgeschaltet und in Transistorengruppen (5) verteilt sind,
- Steuervorrichtungen (6), die jeweils diesen Gruppen zugeordnet und dazu bestimmt sind, die Transistoren zu steuern,
- Einrichtungen (8) zur Erzeugung von Stromimpulsen, die das Steuern der Transistoren mittels Leitung und Sperrung ermöglichen, und
- Impulstransformatoren (10), die jeweils den Steuervorrichtungen (6) zugeordnet sind und mittels derer die Einrichtungen (8) zur Impulserzeugung mit diesen Steuervorrichtungen gekoppelt sind,
und dadurch, dass jede der Steuervorrichtungen (6) umfasst:
- Einrichtungen (24) zur Dämpfung der durch die Entmagnetisierung des entsprechenden Transformators hervorgerufenen Spannung,
- Einrichtungen (26) zur bidirektionalen Spannungsspitzenbegrenzung, und
- Einrichtungen (28) zur monodirektionalen Spannungsspitzenbegrenzung.

2. Wandler nach Anspruch 1, **dadurch gekennzeichnet, dass** die Transistoren Feldeffekttransistoren mit isolierter Steuerelektrode (4) sind.

3. Wandler nach einem der Ansprüche 1 und 2, **dadurch gekennzeichnet, dass** die Dämpfungseinrichtungen (24) zwischen den Enden des Sekundärkreises (20) des entsprechenden Transformators (10) geschaltet sind.

4. Wandler nach Anspruch 3, **dadurch gekennzeichnet, dass** die Dämpfungseinrichtungen einen elektrischen Widerstand (24) umfassen.

5. Wandler nach einem der Ansprüche 1 bis 4, **dadurch gekennzeichnet, dass** die bidirektionalen Spitzenbegrenzungseinrichtungen (26) zwischen der die Sources verbindenden Leitung (30) und der die Steuerelektroden verbindenden Leitung (32) der Transistoren der genannten Reihe geschaltet sind.

6. Wandler nach Anspruch 5, **dadurch gekennzeichnet, dass** die bidirektionalen Spitzenbegrenzungseinrichtungen (26) aus der Gruppe gewählt werden, die eine bidirektionale Zener-Diode, zwei entgegengesetzt geschaltete Zener-Dioden und eine Zener-Diode umfasst, die in einer Diodenbrücke angeordnet ist.

7. Wandler nach einem der Ansprüche 1 bis 6, **dadurch gekennzeichnet, dass** die monodirektionalen Spitzenbegrenzungseinrichtungen (28) zwischen der die Drains verbindenden Leitung (36) und der die Steuerdioden verbindenden Leitung (32) der Transistoren der genannten Reihe geschaltet sind.

8. Wandler nach einem der Ansprüche 1 bis 6, **dadurch gekennzeichnet, dass** die monodirektionalen Spitzenbegrenzungseinrichtungen (28) zwischen der die Drains verbindenden Leitung (36) und der die Sources verbindenden Leitung (30) der Transistoren der genannten Reihe geschaltet sind.

9. Wandler nach einem der Ansprüche 7 und 8, **dadurch gekennzeichnet, dass** die monodirektionalen Spitzenbegrenzungseinrichtungen (28) aus der Gruppe gewählt werden, die eine bidirektionale Zener-Diode, eine Zener-Diode und eine entgegengesetzt geschaltete Zener-Diode sowie eine Zener-Diode umfasst, die in einer Diodenbrücke angeordnet ist.

10. Wandler nach einem der Ansprüche 1 bis 9, **dadurch gekennzeichnet, dass** der Primärkreis jedes Impulsgenerators (10) eine einzige leitfähige Windung (18) umfasst und der Sekundärkreis eine einzige leitfähige Windung (20).

11. Wandler nach Anspruch 10, **dadurch gekennzeichnet, dass** er eine einzige elektrischen Leitung (18) umfasst, die die leitfähige Windung des Primärkreises jeder der Impulsgeneratoren (10) bildet.

12. Wandler nach einem der Ansprüche 1 bis 11, **dadurch gekennzeichnet, dass** Pulserzeugungseinrichtungen eine Wechselrichterbrücke (58, 60, 62, 64) umfassen.

## Claims

1. Pulse power switch capable of delivering high current pulses of short duration, this switch being **characterized in that** it comprises:
- a matrix (2, 68) of transistors, this matrix comprising at least one row of isolated-gate transistors (4), these transistors being connected in parallel and distributed in groups (5) of transistors;
- control devices (6) which are respectively associated with these groups and intended to control the transistors;
- current pulse-generating means (8) which allow the transistors to be controlled by turning them on and off; and
- pulse transformers (10) which are respectively associated with the control devices (6) and via which the pulse-generating means (8) are coupled to these control devices;
and **in that** each of the control devices (6) comprises:
- means (24) for attenuating the voltage due to the demagnetization of the corresponding transformer;
- two-directional voltage-clipping means (26); and
- one-directional voltage-clipping means (28).

2. Switch according to Claim 1, **characterized in that** the transistors are isolated-gate field-effect transistors (4).

3. Switch according to either of Claims 1 and 2, **characterized in that** the attenuating means (24) are connected between the ends of the secondary circuit (20) of the corresponding transformer (10).

4. Switch according to Claim 3, **characterized in that** the attenuating means comprise an electrical resistor (24).

5. Switch according to any one of Claims 1 to 4, **characterized in that** the two-directional clipping means (26) are connected between the line (30) joining the sources and the line (32) joining the gates of the transistors of the said row.

6. Switch according to Claim 5, **characterized in that** the two-directional clipping means (26) are chosen from the group comprising a two-directional Zener diode, two back-to-back Zener diodes, and a Zener diode placed within a diode bridge.

7. Switch according to any one of Claims 1 to 6, **characterized in that** the one-directional clipping means (28) are connected between the line (36) joining the drains and the line (32) joining the gates of the transistors of the said row.

8. Switch according to any one of Claims 1 to 6, **characterized in that** the one-directional clipping means (28) are connected between the line (36) joining the drains and the line (30) joining the sources of the transistors of the said row.

9. Switch according to either of Claims 7 and 8, **characterized in that** the one-directional clipping means (28) are chosen from the group comprising a two-directional Zener diode, a Zener diode and a back-to-back diode, and a Zener diode placed within a diode bridge.

10. Switch according to any one of Claims 1 to 9, **characterized in that**, in each pulse transformer (10), the primary circuit comprises a single conducting turn (18) and the secondary circuit comprises a single conducting turn (20).

11. Switch according to Claim 10, **characterized in that** it comprises a single electrical line (18) constituting the conducting turn of the primary circuit of each of the pulse transformers (10).

12. Switch according to any one of Claims 1 to 11, **characterized in that** the pulse-generating means comprise an inverter bridge (58, 60, 62, 64).
